(19) Europäisches Patentamt / European Patent Office / Office européen des brevets

(11) **EP 3 204 785 B1**

(12) **EUROPÄISCHE PATENTSCHRIFT**

(45) Veröffentlichungstag und Bekanntmachung des Hinweises auf die Patenterteilung:
**25.09.2024  Patentblatt 2024/39**

(21) Anmeldenummer: **15787906.5**

(22) Anmeldetag: **07.10.2015**

(51) Internationale Patentklassifikation (IPC):
**G01R 33/48** (2006.01)   **G01R 33/561** (2006.01)
**G01R 33/565** (2006.01)

(52) Gemeinsame Patentklassifikation (CPC):
**G01R 33/5614; G01R 33/4824; G01R 33/56518**

(86) Internationale Anmeldenummer:
**PCT/EP2015/073107**

(87) Internationale Veröffentlichungsnummer:
**WO 2016/058876 (21.04.2016 Gazette 2016/16)**

(54) **VERFAHREN ZUR ERSTELLUNG EINER RADIALEN ODER SPIRALFÖRMIGEN MRT-AUFNAHME**

METHOD FOR PRODUCING A RADIAL OR SPIRAL MRI ACQUISITION

PROCÉDÉ DE RÉALISATION D'UNE ACQUISITION D'IRM RADIALE OU HÉLICOÏDALE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **07.10.2014  DE 102014220328**

(43) Veröffentlichungstag der Anmeldung:
**16.08.2017  Patentblatt 2017/33**

(73) Patentinhaber: **Sirona Dental Systems GmbH**
**64625 Bensheim (DE)**

(72) Erfinder:
• **RASCHE, Volker**
**89155 Erbach (DE)**
• **WUNDRAK, Stefan**
**64625 Gronau (DE)**

(74) Vertreter: **Özer, Alpdeniz et al**
**Sirona Dental Systems GmbH**
**Corporate Legal**
**Fabrikstraße 31**
**64625 Bensheim (DE)**

(56) Entgegenhaltungen:
**WO-A2-2008/132659   DE-A1- 10 337 932**
**US-A- 4 721 912**

• **BRAU AC, JOHNSON GA: "The impact of view order on steady magnetization in radial sampling", PROCEEDINGS OF THE INTERNATIONAL SOCIETY FOR MAGNETIC RESONANCE IN MEDICINE, ISMRM, 11TH SCIENTIFIC MEETING AND EXHIBITION, TORONTO, CANADA, 10-16 JULY 2003, 26 June 2003 (2003-06-26), pages 296, XP040587635**
• **DAVIDE PICCINI ET AL: "Spiral phyllotaxis: The natural way to construct a 3D radial trajectory in MRI", MAGNETIC RESONANCE IN MEDICINE., vol. 66, no. 4, 5 April 2011 (2011-04-05), US, pages 1049 - 1056, XP055247046, ISSN: 0740-3194, DOI: 10.1002/mrm.22898**
• **STEFANIE WINKELMANN ET AL: "An Optimal Radial Profile Order Based on the Golden Ratio for Time-Resolved MRI", IEEE TRANSACTIONS ON MEDICAL IMAGING, IEEE SERVICE CENTER, PISCATAWAY, NJ, US, vol. 26, no. 1, 1 January 2007 (2007-01-01), pages 68 - 76, XP011152669, ISSN: 0278-0062, DOI: 10.1109/TMI.2006.885337**
• **WUNDRAK STEFAN ET AL: "A Small Surrogate for the Golden Angle in Time-Resolved Radial MRI Based on Generalized Fibonacci Sequences", IEEE TRANSACTIONS ON MEDICAL IMAGING, IEEE SERVICE CENTER, PISCATAWAY, NJ, US, vol. 34, no. 6, 1 June 2015 (2015-06-01), pages 1262 - 1269, XP011582649, ISSN: 0278-0062, [retrieved on 20150529], DOI: 10.1109/TMI.2014.2382572**

• TSAI C-M ET AL: "Reduced aliasing artifacts using variable-density k-space sampling trajectories", MAGNETIC RESONANCE IN MEDICINE, JOHN WILEY & SONS, INC, US, vol. 43, no. 3, 1 March 2000 (2000-03-01), pages 452 - 458, XP002179553, ISSN: 0740-3194, DOI: 10.1002/(SICI)1522-2594(200003)43:3<452::AID-MRM18>3.0.CO;2-B

## Beschreibung

Technisches Gebiet

Die Erfindung betrifft ein Verfahren zur Erstellung einer MRT-Aufnahme, bei dem eine radiale k-Raum-Trajektorie mit einem konstanten Winkelinkrement Psi benutzt wird.

Der Ablauf eines üblichen Aufnahmeprozesses kann wie folgt zusammenfassend beschrieben werden: Nach der Positionierung eines Patienten in einem MR-Tomographen erfolgt die Positionierung von Spulen bezüglich des Patienten. Die Erstellung einer Übersichtsaufnahme ermöglicht die Planung der Aufnahmegeometrie an einer mit dem MR-Tomographen zusammenwirkenden Workstation und es erfolgt die Aufnahme der k-Raum-Daten. Nach der Bildrekonstruktion auf einem Rekonstruktionsrechner erfolgt eine Anzeige der Bilder an der Workstation zur Betrachtung und zur Diagnose durch den Betrachter. Ausgehend von diesem Ablauf betrifft die Erfindung die Aufnahme der k-Raum-Daten.

"Balanced Steady-State Free Precession"-MRT-Sequenzen (auch b-FFE, TrueFISP oder FIESTA [15] genannt) werden für die schnelle Bildgebung eingesetzt, um einen höheres Signal-zu-Rausch-Verhältnis zu erhalten, z.B. im Vergleich zu FLASH-Sequenzen. Weiterhin wird die b-SSFP Sequenz eingesetzt, um einen schnellen T1/T2-Kontrast zu erhalten, welcher z.B. wichtig für die Bildgebung des Diskus Artikularis im Kiefergelenk ist [23]. FLASH kann im Vergleich nur T1- oder Protonen-gewichteten Kontrast erzeugen.

Der k-Raum wird durch eine radiale k-Raum-Trajektorie abgetastet, die aus einer Vielzahl von radialen Profilen zusammengesetzt ist, von denen jede durch den Mittelpunkt des k-Raums geht [16]. Radiale Trajektorien sind weniger anfällig für Bewegungsartefakte und werden deswegen oft verwendet, um dynamische physiologische Abläufe aufzunehmen [3] .

Darüber hinaus sind radiale Trajektorien im Vergleich zu kartesischen Trajektorien robuster in Bezug auf eine in Drehrichtung gesehene nicht vollständige Abtastung, welche in einer zeitaufgelösten Bildgebung verwendet wird, um die zeitliche Auflösung zu verbessern.

Eine Rekonstruktion mit einem verschiebbaren zeitlichen Ausschnitt wird verwendet, um die Aktualisierungsrate der Aufnahme weiter zu erhöhen. In herkömmlichen radialen Trajektorien mit einer uniformen Verteilung der radialen Profile ist die Größe des für die Rekonstruktion verwendeten zeitlichen Ausschnitts durch die Zahl der Profile pro Bild vorgegeben und muss vor der Bilderfassung ausgewählt werden. In den meisten Fällen ist die für die Rekonstruktion optimale Größe des zeitlichen Ausschnitts vorher nicht bekannt. Die Änderung der Größe des zeitlichen Ausschnitts erfordert eine neue Bilderfassung des Objekts mit einer angepassten radialen Trajektorie.

Stand der Technik

Es wurde in [33] nachgewiesen, dass dann, wenn die radialen Profile unter Verwendung des Goldenen Winkels von 111,24...° so angeordnet werden, dass jeweils ein Abstand der aufeinanderfolgenden Profile mit dem Winkelinkrement des Goldenen Winkels vorliegt, für eine beliebige Zahl n von aufeinanderfolgenden Profilen eine nahezu gleichmäßige Verteilung der Profile erreicht werden kann. Dieser Goldene Winkel ist die optimale Anordnung, falls die Zahl n der radialen Profile, die zur Rekonstruktion eines Bildes benutzt werden sollen, nicht konstant ist bzw. vor der Aufnahme feststeht [2]. Das hat zur Folge, dass die Zahl n der Profile im Rekonstruktionsausschnitt und damit der Grad der Unterabtastung nachträglich an unterschiedliche Bewegungsgrade angepasst werden kann.

Der Vollständigkeit halber wird darauf hingewiesen, dass in der vorliegenden Anmeldung der Vollkreis als Pi angenommen wird statt mit 2*Pi, da in MRI bei den meisten Sequenzen die Zentralstrahltrajektorie verwendet wird.

Wird der Vollkreis im Goldenen Schnitt tau = (1+sqrt (5))/2 geteilt, erhält man den Goldenen Winkel $Psi_{golden}$ = Pi / tau von 111,2461...° und den dazugehörigen Supplementwinkel ("kleiner Goldener Winkel") Pi - $Psi_{golden}$ von 68,7538...°.

Der Goldene Winkel wird aufgrund der inkohärenten Artefakte u.a. in Kombination mit Compressed Sensing eingesetzt [5], so auch in der WO 2013/159044 A1.

Die Kombination der Goldenen Winkel-Anordnung mit Balanced SSFP ist mit Nachteilen behaftet, da das große radiale Winkelinkrement von 111,246° durch ein sich ständig und abrupt änderndes Gradientenschema realisiert wird. Dieses Gradientenschema wiederum induziert große, sich abrupt ändernde Wirbelströme in den leitenden Teilen des Hauptmagneten und führt dadurch zu sich ständig ändernden Inhomogenitäten des Hauptmagnetfeldes. Diese Wirbelstromeffekte beeinflussen den Gleichgewichtszustand der balanced SSFP-Sequenz und führen dadurch zu starken Bildartefakten [1].

Bieri et al. schlagen zwei Techniken zur Kompensation dieser Artefakte vor [16]:

1. Die k-Raum-Profile werden so umsortiert, dass immer zwei k-Raum-Profile mit gleichem oder ähnlichem Winkel hintereinander gemessen werden. Dadurch heben sich die Wirbelstromeffekte auf und der Gleichgewichtszustand der SSFP-Sequenz wird gehalten, was auch als "spoke-pairing" bezeichnet wird. Allerdings wird auch die Zeitauflösung der dynamischen Aufnahme halbiert. "Spoke" ist ein Synonym für ein k-Raum-Profil, alle k-Raum Profile zusammen sind die K-Raum-Trajektorie.

2. Das Wirbelstrom-induzierte Signal wird über einen kleinen Dephasing-Gradienten, der senkrecht zur Schichtlage ausgerichtet ist, unterdrückt. Dazu wird die Amplitude des Rephasierungsgradienten modifiziert ("through slice equilibration"). In der Praxis und bei sehr großen Winkelinkrementen führt diese Technik nur zu unbefriedigenden Ergebnissen, da die Wirbelströme, die kompensiert werden können, limitiert sind. Weiterhin funktioniert diese Lösung nur für zweidimensionale Aufnahmen.

Alternativ werden FLASH-Sequenzen eingesetzt, die ein schlechteres SNR haben und einen anderen Kontrast zeigen.

Es ist weiterhin erstrebenswert, ein konstantes Winkelinkrement Psi zu finden, das für jede Anzahl von n Profilen eine gute Uniformität erreicht. Die optimale Verteilung für eine Aufnahme mit genau n Profilen liegt bei einem Winkelinkrement von $Psi_{opt} = Psi_{uniform} = 180°/n$, da so alle Lücken zwischen benachbarten Profilen gleich groß sind.

Ein gleichförmiges Winkelinkrement $Psi_{uniform} = Pi/P$ liefert für eine vorgegebene Anzahl P von radialen Profilen die bestmögliche gleichförmige radiale Abtast-Trajektorie. Wenn die Anzahl P der Profile variabel ist, hat sich gezeigt, dass die Trajektorie mit dem Goldenen Winkel eine optimale radiale Verteilung für eine zufällige Anzahl von Profilen ist.

Um Abtast-Trajektorien zu vergleichen, wird die Abtasteffizienz berechnet. Die Güte einer nicht-optimalen Verteilung wird über die Abtasteffizienz definiert. Eine hohe Uniformität führt zu einer hohen Abtasteffizienz. Die Abtasteffizienz SE (Psi, P) für ein gegebenes Winkelinkrement Psi und für P radiale Profile entspricht dem Verhältnis des Signal-Rausch-Abstandes $SNR_{uniform}$ der gleichförmigen Abtastung und des Signal-Rausch-Abstandes $SNR_{Psi}$ der Abtastung mit dem Winkelinkrement Psi [17]. Der Signal-Rausch-Abstand SNR kann unmittelbar aus der Abtastungsdichte des Abtastungsschemas abgeleitet werden [3]. Die Abtasteffizienz ist definiert als:

$$SE_P^{\psi} = \frac{SNR_{\psi}}{SNR_{uniform}} = \sqrt{\frac{\pi^2/P}{\sum_{i=0}^{P-1}(\Delta\Phi_i)^2}}$$

,

wobei $\Delta\Phi_i$ die durchschnittliche azimutale Entfernung des Profils i zu seinen zwei Nachbarn ist. Die Abtasteffizienz des Goldenen Winkels ist größer als 0,9732 für jede Anzahl von Profilen P, im Rest des Textes "n" genannt.

Mittels der "pseudo golden-ratio spiral imaging"-Methode ist es möglich, Echtzeit MRT-Aufnahmen einer sprechenden Person mit guter Bildqualität bei gleichzeitig akzeptabler Tonqualität zu erzeugen [37].

Aus der WO 2008/132659 A2 ist eine Vorrichtung und ein Verfahren zur Erzeugung von MRT-Aufnahmen eines Patienten bekannt, wobei die k-Raum Trajektorien einem so genanntes "Periodically Rotated Overlapping Parallel Lines with Enhanced Reconstruction"-Konzept folgen [38].

Die Aufgabe der Erfindung besteht darin, auch dann, wenn die Zahl der radialen Profile, die zur Rekonstruktion eines Bildes benutzt werden sollen, nicht konstant ist, bzw. nicht vor der Aufnahme feststeht, eine b-SSFP Sequenz einsetzen zu können, um beispielsweise einen schnellen T1/T2-Kontrast zu erhalten, welcher z.B. wichtig für die Bildgebung des Diskus Artikularis im Kiefergelenk ist. Dabei sollen Bildartefakte, die durch Wirbelströme hervorgerufen werden, so gut wie möglich vermieden werden.

Offenbarung der Erfindung

Gemäß der Erfindung wird ein Verfahren gemäß Anspruch zur Erstellung einer dynamischen MRI-Aufnahme bereitgestellt, bei dem eine radiale k-Raum-Trajektorie mit einem konstanten Winkelinkrement Psi benutzt wird, wobei das Winkelinkrement Psi in einem Winkelbereich von 5 bis 55 Grad liegt und berechnet wird nach der Formel

$$\psi_{N,M} = \frac{\pi}{N + \frac{1}{M+\tau-1}}$$

wobei N zwischen 3 und 35 und M zwischen 1 und 5 liegt und wobei tau = (1+sqrt(5))/2. Für tau gilt damit auch: 1/tau = tau -1.

Durch N zwischen 3 und 35 wird sichergestellt, dass weder der Goldene Winkel noch der komplementäre Goldene Winkel enthalten sind.

Das Winkelinkrement $Psi_1$ ist der bekannte Goldene Winkel, $Psi_2$ der zu dem Goldenen Winkel komplementäre Winkel, bekannt als kleiner Goldener Winkel, und gemäß der Erfindung sind die $Psi_N$ mit $N > 2$ eine Reihe von kleiner werdenden irrationalen Winkelinkrementen mit ähnlich optimalen Eigenschaften in der fully balanced SSFP wie der bekannte Goldene Winkel. Dabei steht die Kurzschreibweise $Psi_1$ für Psi (1,1) und $Psi_2$ für Psi(2,1), also für M=1. Vorteilhafterweise kann M = 1 und N mindestens 3 sein, sodass sich für das Winkelinkrement Psi die folgende Formel ergibt: $Ps1_{N,M} = Pi / (tau + N - 1)$:

$$\psi_N = \frac{\pi}{\tau + N - 1}$$

wobei N zwischen 3 und 35 liegt und wobei tau = (1+sqrt(5))/2 ist.

Für die Kombination mit fully balanced SSFP sind die gegenüber dem Goldenen Winkel und dem kleinen Goldenen Winkel kleineren Winkel vorteilhaft, wenn sie in etwa die gleichen Eigenschaften bezüglich der Abtasteffizienz bei einer variablen Anzahl von Profilen P aufweisen.

Die Erfindung benutzt ein $Psi_N$, das hinreichend klein ist, so dass keine Bildartefakte durch die fully balanced SSFP mehr auftreten.

Es gibt viele andere sub-optimale kleine Winkel, die hinreichend gute Eigenschaften bezüglich der Abtasteffizienz bei einer variablen Anzahl von Profilen P besitzen.

Gemäß einer vorteilhaften Weiterbildung ergibt sich das Winkelinkrement dadurch, dass M = 2 und N mindestens 3 ist. Vorteilhafterweise ist das Winkelinkrement dadurch bestimmt, dass N mindestens 5, vorzugsweise mindestens 7 ist. Damit ergibt sich für die b-SFFP Bildgebung in den meisten Situationen ein hinreichend kleiner Winkel. Größere N haben den Nachteil, dass die Sampling-Effizienz erst ab der 2. Umdrehung gut ist, was als Bedingung P>2N formuliert werden kann. Bei großen N ergibt sich damit eine große Mindest-Fensterbreite für die Rekonstruktion. Im Beispiel von N=30 wären das mindestens 60 radiale Profile für die Rekonstruktion, was in Anwendungen wie Compressed Sensing und Parallel Imaging viel ist. Ein optimales N ist daher möglichst klein aber groß genug, dass keine Artefakte mehr auftreten. N=7 ist ein guter Kompromiss. Vorteilhafterweise kann eine Anzahl n von Profilen für die Bildrekonstruktion gewählt werden, wobei die Anzahl n Teil einer modifizierten Fibonacci-Folge $G^{N,M}$ ist mit

$$G^{N,M}_1 = 1+(M-1)N, \quad G^{N,M}_2 = N, \quad G^{N,M}_n = G^{N,M}_{n-1} + G^{N,M}_{n-2}$$

Der Vorteil liegt darin, dass an diesen Punkten die Abtasteffizienz ein lokales Optimum besitzt.

Ein weiterer Gegenstand, der nicht in den durch die Ansprüche definierten Schutzumfang der Erfindung fällt, ist ein Verfahren zur Erstellung einer dynamischen MRI-Aufnahme, bei dem eine radiale k-Raum-Trajektorie mit einem konstanten Winkelinkrement Psi benutzt wird, wobei die MRI-Sequenz nach dem Verfahren der fully balanced SSFP betrieben wird und wobei bei einem Winkelinkrement Psi, das von dem Winkelinkrement der optimalen Verteilung von n radialen Profilen $Psi_{opt} = 180°/n$ abweicht, die minimale Abtasteffizienz des Winkelinkrements Psi für n > 21 größer als 0,95, vorteilhafterweise größer als 0,97 ist. Das Winkelinkrement Psi liegt dabei in einem Winkelbereich von 5 bis kleiner als 68,7537 Grad, insbesondere von 5 bis 55 Grad oder dem entsprechenden Supplementwinkel.

Damit ist sichergestellt, dass Bildartefakte in ausreichendem Maß unterdrückt werden und dass eine geeignete Bildqualität bereitgestellt werden kann.

Die minimale Abtasteffizienz für eine verschiedene Anzahl von n Profilen für den Goldenen Winkel $Psi_1$ = 111,246 und die minimale Abtasteffizienz für eine verschiedene Anzahl von n Profilen für einen verringerten Goldenen Winkel wie z.B. $Psi_7$ = 23,628... weisen ab einer Mindestanzahl von Profilen $n_{min}$ die gleiche untere Schranke auf. Dies gilt für alle $Psi_N$ und für beliebig große N.

Vorteilhafterweise kann das Winkelinkrement Psi so ausgewählt werden, dass die minimale Abtasteffizienz des Winkelinkrements Psi für n > 21 Profile größer als 0,97 ist.

Eine Rekonstruktion zu Bildern, insbesondere zu einem 3D-Datensatz, erfolgt über eine Gridding-Methode oder über eine gefilterte Rückprojektions-Methode.

Dabei können vor der Rekonstruktion k-Raum-Daten bezüglich eines Gradienten-induzierten Phasenfehlers korrigiert werden, indem die komplementäre Phaseninformation von Paaren von entgegengesetzten oder nahezu entgegengesetzten radialen Profilen benutzt wird.

Vorteilhafterweise können pro Winkelposition mindestens zwei Profile gemessen werden, was auch als spoke-pairing bezeichnet wird, um eine weitere Reduktion der Wirbelstrominduzierten Bildartefakte zu erreichen.

Vorteilhafterweise kann eine T1-/T2- oder eine Proton-Density-Mapping-Sequenz zur Aufnahme verwendet werden, um die Relaxationsparameter innerhalb einer einzigen Aufnahme zu bestimmen.

Ganz besonders vorteilhaft ist das Verfahren, wenn die MRI-Aufnahme dynamisch ist, da das zeitliche Rekonstruktionsfenster retrospektiv an die konkrete Bewegungsgeschwindigkeit der Physiologie, z.B. der Herzfrequenz, angepasst werden kann.

Vorteilhafterweise kann die MRI-Sequenz nach dem Verfahren der fully balanced SSFP betrieben werden, da so ein höheres Signal-zu-Rausch-Verhältnis erreicht wird und diese Sequenz aufgrund des T1-/T2-Kontrastes zum Beispiel gut für die Bildgebung des Diskus Artikularis im Kiefergelenk geeignet ist.

Vorteilhafterweise können bei der Aufnahme mehrere Spulen verwendet werden und Bilder über ein auf der parallelen Bildgebung basierendes Verfahren rekonstruiert werden. Dadurch kann eine geringere Abtastdichte des k-Raums verwendet werden, ohne Aliasingartefakte im rekonstruierten Bild zu verursachen.

Weiterhin können Bilder über ein auf Compressed Sensing basierendes Verfahren rekonstruiert werden.

Es ist für die Auswertung von Bildern von besonderem Vorteil, wenn verbleibende Wirbelstrom-Artefakte über ein "through-slice equilibration"-Verfahren weiter reduziert werden, um die Bildqualität zu erhöhen.

Der Grundgedanke der Erfindung besteht darin, kleinere Winkel mit ähnlich guten Eigenschaften des Goldenen Winkels anzuwenden, die insbesondere in Kombination mit einer b-SSFP Sequenz für die dynamische Bildgebung die Bildartefakte gegenüber der Verwendung des Goldenen Winkels verringern. Bildartefakte, die bislang durch sich schnell ändernde Wirbelströme, hervorgerufen durch die Winkelveränderung mit dem großen Goldenen Winkel, erzeugt wurden, werden durch die Verwendung der kleineren Winkelinkremente vermieden.

Vorzugsweise werden neue Winkelinkremente vorgeschlagen, die aus einer verallgemeinerten Fibonacci-Folge abgeleitet sind. Diese verringerten Goldenen Winkel weisen im vergleich mit dem Goldenen Winkel ähnliche Eigenschaften auf, wodurch diese Winkelinkremente für dynamische MRI in Verbindung mit fully balanced SSFP Sequenzen vorteilhaft sind.

Kurze Beschreibung der Zeichnung

Das erfindungsgemäße Verfahren wird anhand der Zeichnung erläutert. Es zeigen:

Fig. 1     eine Tabelle mit erfindungsgemäßen Winkelinkrementen Psi für M = 1, 2 oder 3 und N = 3 - 7;

Fig. 2     eine dynamische Aufnahme eines Kiefergelenks mit einer b-SSFP-Sequenz mit Winkeln $Psi_1$ bis Psis und einer Referenzaufnahme;

Fig. 3     die Verteilung von radialen Profilen P = 3, 5, 11, 15, 28 und 61 für Winkelinkremente $Psi_N$ mit N = 1, 3, 5 und 7 und die Abtasteffizienz SE;

Fig. 4     die Verteilung der minimalen Abtasteffizienz SE über einen Winkelbereich von 180°;

Fig. 5     die Abtasteffizienz SE für $Psi_5$ im Vergleich zu dem Winkelinkrement des Goldenen Winkels;

Fig. 6     die Abtasteffizienz SE für $Psi_7$ im Vergleich zu dem Winkelinkrement des Goldenen Winkels.

Ausführungsbeispiel

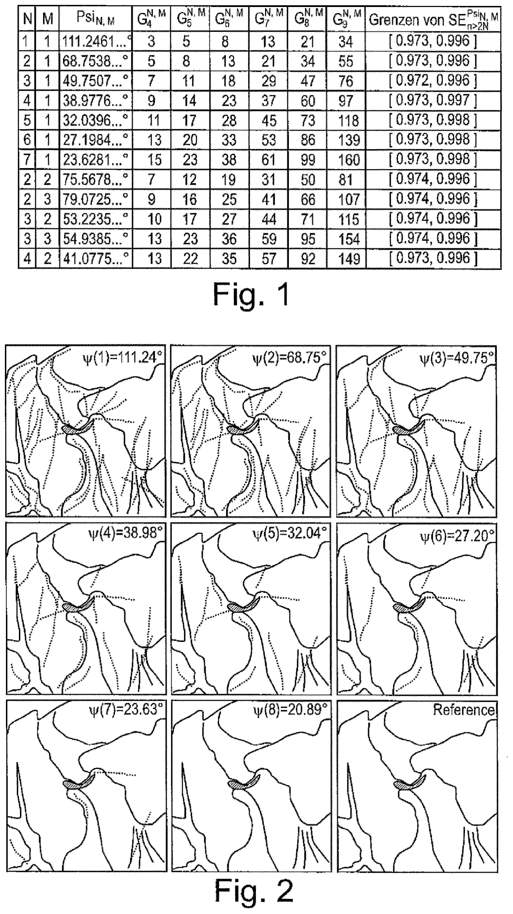

Fig. 1 zeigt eine Tabelle mit erfindungsgemäßen Winkelinkrementen Psi für M = 1 und N = 3 - 7, sodass sich erfindungsgemäße Winkelinkremente $Psi_3$ bis $Psi_7$ von 49,75...° bis 23,6281...° ergeben.

Die Winkelinkremente sind irrational, in der konkreten Implementierung der Erfindung wird aber eine numerische Näherung benutzt. Weitere Winkelinkremente $Psi_N$ sind:

| $Psi_N$ | N |
|---|---|
| 20,886434218636708... | 8 |
| 18,714843408803084... | 9 |
| 16,952290809269876... | 10 |
| 15,493154880963477... | 11 |
| 14,265296809351289... | 12 |
| 13,217766980806575... | 13 |
| 12,313557359254249... | 14 |
| 11,525138191507267... | 15 |

(fortgesetzt)

| $Psi_N$ | N |
|---|---|
| 10,831606200941504... | 16 |
| 10,216803992712247... | 17 |
| 9,668045514836129... | 18 |
| 9,175231325586566... | 19 |
| 8,730221324604273... | 20 |
| 8,326381580011979... | 21 |
| 7,958251370987027... | 22 |
| 7,621294815891128... | 23 |
| 7,311713034528165... | 24 |
| 7,026300303881501... | 25 |
| 6,762332637943018... | 26 |
| 6,517480573502168... | 27 |
| 6,289740241092741... | 28 |
| 6,077378399537631... | 29 |
| 5,878888241685868... | 30 |
| 5,692953586679246... | 31 |
| 5,518419658955621... | 32 |
| 5,354269082488171... | 33 |
| 5,199602035704745... | 34 |
| 5,053619749390260... | 35 |

Für ausgewählte Werte von M > 1, hier M = 2 und N = 3, 4 ergeben sich Winkelinkremente $Psi_{2,3}$ = 53,2235... und $Psi_{2,4}$ 41,0775... Für M = 3 und N = 3 ergibt sich ein Winkelinkrement $Psi_{3,3}$ von 54,9385...

Weiter ergeben sich für M = 2 und N = 5 - 11 beispielhaft folgende Winkelinkremente:

| $Psi_{N,M}$ | N, M |
|---|---|
| 33,445027267682470... | 5,2 |
| 28,204474872272382... | 6,2 |
| 24,383748140492692... | 7,2 |
| 21,474675482864956... | 8,2 |
| 19,185744201605331... | 9,2 |
| 17,337756625763216... | 10,2 |
| 15,814491083709555... | 11,2 |

Fig. 2 zeigt eine dynamische Aufnahme eines Kiefergelenks mit einer b-SSFP-Sequenz mit den bekannten Winkelinkrementen $Psi_1$ und $Psi_2$ und einer Referenzaufnahme mit einem Winkel Psi = 1° sowie mit erfindungsgemäßen Winkelinkrementen $Psi_3$ bis $Psi_8$.

Es ist zu erkennen, dass die Artefakte mit kleiner werdendem Winkelinkrement $Psi_1$ bis $Psi_8$ verschwinden und ab dem Winkelinkrement $Psi_6$ eine akzeptable Bildqualität erreicht wird. Der Diskus Artikularius ist aufgrund des b-SSFP T1/T2-Kontrastes sehr gut zu sehen.

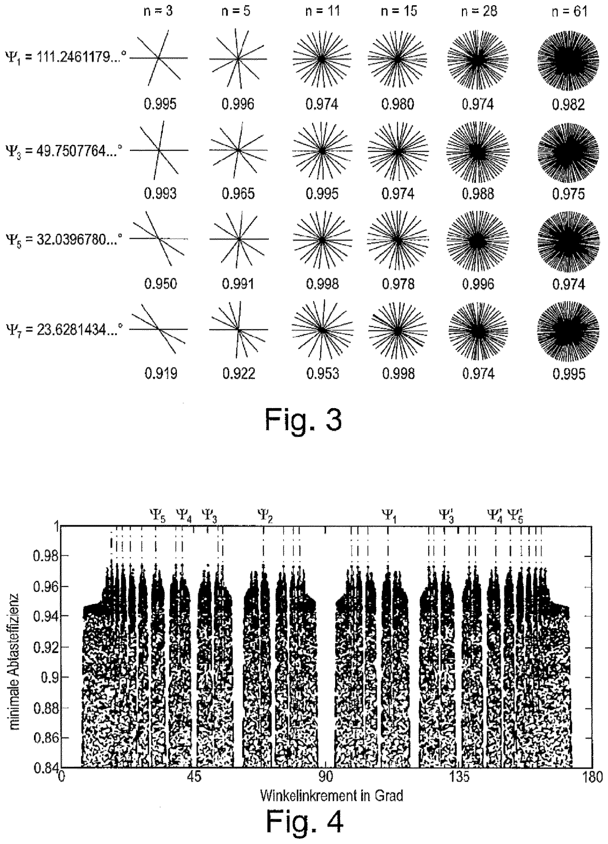

Fig. 3 zeigt die Verteilung von radialen Profilen P = 3, 5, 11, 15, 28 und 61 für Winkelinkremente $Psi_N$ mit N = 1, 3, 5 und 7 und enthält unter jeder Verteilung die jeweilig dazugehörige Abtasteffizienz SE. So ergibt sich für Psis bei n = 61 Profilen eine Abtasteffizienz SE von 0,974.

Fig. 4 zeigt die minimale Abtasteffizienz SE als numerische Simulation. Auf der Y-Achse ist die minimale Abtasteffizienz SE zwischen 0,84 und 1,00 dargestellt, auf der x-Achse der Winkel Psi von 0 bis 180° mit einer Auflösung von 0,002°. Die minimale Abtasteffizienz wurde dabei für jeden Winkel über den Bereich n=(21;10^4) (Anzahl der Profile) bestimmt. Angegeben sind die Winkelinkremente $Psi_1$ bis Psis und die Supplementwinkel $Psi'_3$ bis $Psi'_5$ sowie weitere geeignete Winkel, die durch zum oberen Rand hin verlängerte unterbrochene Linien angegeben sind. Die fetten unterbrochenen Linien entsprechen Winkelinkrementen $Psi_N$, wobei jedes dieser Winkelinkremente Nebenmaxima aus dem Winkelinkrement $Psi_{N,M}$ aufweist, dargestellt durch die dünneren unterbrochenen Linien. Das Diagramm ist symmetrisch zu 90°, sodass die Supplementwinkel $Psi'_3$ bis $Psi'_5$ erkennbar sind.

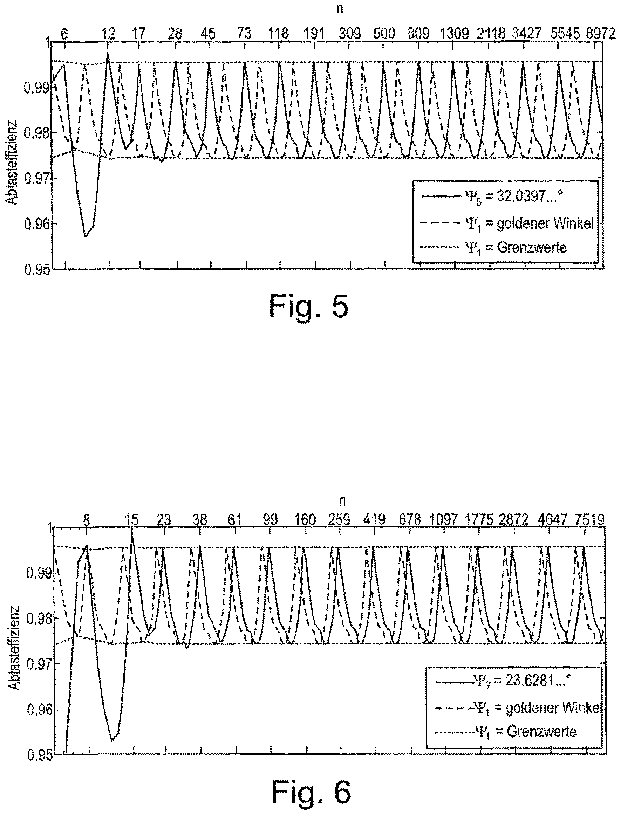

In Fig. 5 und 6 ist die Abtasteffizienz SE für Psis und für $\text{Psi}_7$ jeweils im Vergleich zu dem Winkelinkrement des Goldenen Winkels $\text{Psi}_1$ = 111,246... dargestellt. Dabei wird auf der x-Achse für die Anzahl der Profile n ein logarithmischer Maßstab verwendet. Die maximale Abtasteffizienz SE wird dann erreicht, wenn n aus der modifizierten Fibonacci-Folge $G^{N,M}$ ist [19].

In dieser Folge ergeben sich für M = 1 und N = 1 und 5 folgende Werte für n:

$$G^{1,1}: \quad 1\ 1\ 2\ 3\ 5\ 8\ 13\ 21\ ...$$
$$G^{5,1}: \quad 1\ 5\ 6\ 11\ 17\ 28\ 45\ 73\ ...$$

Es ist zu erkennen, dass für n > 2N Profile die Abtasteffizienz SE im Wesentlichen zwischen den Grenzwerten des Goldenen Winkels liegt. Bei Psis ist dies ab n = 11 der Fall, bei $\text{Psi}_7$ ist dies ab n = 15 der Fall.

Glossar

Supplementwinkel (englisch: adjacent angle)

Zwei Winkel heißen Supplementwinkel (auch: Supplementärwinkel), Ergänzungswinkel oder kurz E-Winkel, wenn sie sich zu 180° ergänzen. (siehe http://de.wikipedia.org/wiki/Winkel#Supplementwinkel oder E rgänzungswinkel)

$$\psi'_{N,M} = \pi - \psi_{N,M}$$

Jeder Winkel erzeugt die exakt gleiche Profilverteilung wie der passende Supplementwinkel Psi'. Daher auch die Symmetrie zu 90° in Fig. 4.

Compressed Sensing MRI

Compressed Sensing [34] ist in der Lage, aus einer kleinen Zahl von Messungen, die zufällige Linearkombinationen des Signals erfassen, das Ursprungssignal zu rekonstruieren - auch wenn die Zahl der Messungen dabei sehr viel kleiner ist als die Nyquistrate vorgibt. Eine Möglichkeit der quasizufälligen Abtastung des k-Raums sind radiale k-Raum-Trajektorien mit einem Winkelinkrement, das dem Goldenen Winkel entspricht. Über diese Trajektorien und einem nichtlinearen Rekonstruktionsalgorithmus können die Methoden des Compressed Sensing für die schnelle MRI-Bildgebung eingesetzt werden [4].

Parallele Bildgebung

In der Methode der Parallelen Bildgebung wird das Signal aus mehreren Spulenelementen, die in einem Phased-Array angeordnet sind, kombiniert. Zusammen mit den vorher ermittelten Intensitätsprofilen der Spulen können diese zusätzlichen Daten dann genutzt werden um während der Rekonstruktion Unterabtastungsartefakte zu eliminieren. Bekannte Algorithmen sind entweder Bildraum basiert (SENSE) oder k-Raum basiert (GRAPPA) oder eine Kombination aus beiden Methoden. Durch die dadurch mögliche Unterabtastung kann eine deutliche Beschleunigung der MR-Bildgebung erreicht werden. Die Kombination mit Compressed Sensing [4] und dem Goldenen Winkel ermöglicht eine weitere Beschleunigung der Bildgebung.

Quantitative Relaxationsparameter-Bestimmung Inversion-Recovery-Sequenzen bestehen aus einem Inversionspuls in Kombination mit einer balanced SSFP-Sequenz und ermöglichen die simultane Quantifizierung der Relaxationsparameter T1, T2 und relative Protonendichte. Die Kombination mit einer radialen k-Raum Trajektorie und dem Goldenen-Winkel-Inkrement ermöglicht die Bestimmung der Relaxationsparameter innerhalb einer einzigen Aufnahme [35] .

Modellbasierte Bildrekonstruktion

Neben den Methoden der parallelen Bildgebung, des Compressed Sensing und der quantitativen Relaxationsparameter-Bestimmung kann die beschriebene radiale Profilanordnung mit weiteren Komponenten der modellbasierten Bildrekonstruktion kombiniert werden, zum Beispiel durch Einbeziehung von B0-Maps oder Trajectory-Maps [36].

Referenzen

[1] P. C. Lauterbur, "Image Formation by Induced Local Interactions," Nature, vol. 242, no. 190, 1973.

[2] V. Rasche, R. de Boer, D. Holz, and R. Proksa, "Continuous radial data acquisition for dynamic MRI," Magn Reson Med., vol. 34, no. 5, pp. 754-61, 1995.

[3] S. Winkelmann, T. Schaeffter, T. Koehler, H. Eggers, and O. Doessel, "An optimal radial profile order based on the Golden Ratio for time-resolved MRI", IEEE transactions on medical imaging, vol. 26, no. 1,pp. 68-76, Jan. 2007.

[4] L. Feng, R. Grimm, K. Tobias Block, H. Chandarana, S. Kim, J. Xu, L. Axel, D. K. Sodickson, and R. Otazo, "Golden-angle radial sparse parallel MRI: Combination of compressed sensing, parallel imaging, and golden-angle radial sampling for fast and flexible dynamic volumetric MRI", Magnetic resonance in medicine, vol. 72 (2014), S. 707-717.

[5] A. J. Hopfgartner, O. Tymofiyeva, P. Ehses, K. Rottner, J. Boldt, E.-J. Richter, and P. M. Jakob, "Dynamic MRI of the TMJ under physical load", Dento maxillo facial radiology, vol. 42, no. 9, Jan. 2013.

[6] J. Liu, P. Spincemaille, N. C. F. Codella, T. D. Nguyen, M. R. Prince, and Y. Wang, "Respiratory and cardiac self-gated free-breathing cardiac CINE imaging with multiecho 3D hybrid radial SSFP acquisition", Magnetic resonance in medicine, vol. 63, pp. 1230-7, May 2010.

[7] J. Paul, E. Divkovic, S. Wundrak, P. Bernhardt, W. Rottbauer, H. Neumann, and V. Rasche, "High-resolution respiratory self-gated golden angle cardiac MRI: Comparison of self-gating methods in combination with k-t SPARSE SENSE", Magnetic Resonance in Medicine, Jan. 2014.

[8] A. D. Scott, R. Boubertakh, M. J. Birch, and M. E. Miquel, "Adaptive Averaging Applied to Dynamic Imaging of the Soft Palate", Magnetic resonance in medicine, vol. 70, pp. 865-874, 2013.

[9] H. K. Song and L. Dougherty, "k-space weighted image contrast (KWIC) for contrast manipulation in projection reconstruction MRI", Magnetic resonance in medicine, vol. 44, no. 6, pp. 825-32, Dec. 2000.

[10] M. Doneva, "Advances in Compressed Sensing for Magnetic Resonance Imaging", Dissertation, Lübeck 2011.

[11] M. Usman, D. Atkinson, F. Odille, C. Kolbitsch, G. Vaillant, T. Schaeffter, P. G. Batchelor, and C. Prieto, "Motion Corrected Compressed Sensing for Free-Breathing Dynamic Cardiac MRI", Magnetic resonance in medicine, vol. 70, pp. 504-516, 2013.

[12] M. Doneva, H. Eggers, J. Rahmer, P. B"ornert, and A. Mertins, "Highly Undersampled 3D Golden Ratio Radial Imaging with Iterative Reconstruction", in Proc. Intl. Soc. Mag. Reson. Med., vol. 16, 2008, p. 336.

[13] M. Lustig, D. L. Donoho, J. M. Santos, and J. M. Pauly, "Compressed Sensing MRI", Signal Processing Magazine, IEEE, vol. 25, no. 2, pp. 72-82, 2008.

[14] R. W. Chan, E. A. Ramsay, E. Y. Cheung, and D. B. Plewes, "The Influence of Radial Undersampling Schemes on Compressed Sensing Reconstruction in Breast MRI", Magnetic resonance in medicine, vol. 67, pp. 363-377, 2012.

[15] A. Oppelt, R. Graumann, H. Barfuss, H. Fischer, W. Hartl, and W. Schajor, "FISP - a new fast MRI sequence", Electromedia, vol. 54, pp. 15-18, 1986.

[16] O. Bieri, M. Markl, and K. Scheffler, "Analysis and Compensation of Eddy Currents in Balanced SSFP", Magnetic resonance in medicine, vol. 54, pp. 129-137, 2005.

[17] C. M. Tsai and D. G. Nishimura, "Reduced aliasing artifacts using variable-density k-space sampling trajectories", Magnetic resonance in medicine, vol. 43, pp. 452-458, Mar. 2000.

[18] C. Marzec and J. Kappraff, "Properties of Maximal Spacing on a Circle Related to Phyllotaxis and to the Golden Mean", Journal of Theoretical Biology, vol. 103, pp. 201-226, 1983.

[19] A. F. Horadam, "A Generalized Fibonacci Sequence", Amer. Math. Monthly, vol. 69, no. 8, pp. 455-459, 1961.

[20] D. E. Knuth, The Art of Computer Programming, Vol 3. p. 543, Palo Alto, California: Addison-Wesley, 1973.

[21] L. E. Dickson, History of the Theory of Numbers, Vol. 1: Divisibility and Primality. New York: Dover, 2005.

[22] S. Vajda, Fibonacci and Lucas Numbers, and the Golden Section - Theory and Applications. Chichester, England: Ellis Horwood Limited, 1989.

[23] S. Zhang, N. Gersdorff, and J. Frahm, "Real-Time Magnetic Resonance Imaging of Temporomandibular Joint Dynamics", The Open Medical Imaging Journal, vol. 5, pp. 1-7, 2011.

[24] A. Haase, D. Matthaei, W. H"anicke, and K.-D. Merboldt, "FLASH imaging. Rapid NMR imaging using low flipangle pulses", Journal of Magnetic Resonance, vol. 67, pp. 258-266, 1986.

[25] V. Rasche, R. Proska, R. Sinkus, P. Börnert, and H. Eggers, "Resampling of Data Between Arbitrary Grids Using Convolution Interpolation", IEEE transactions on medical imaging, vol. 18, no. 5, pp. 385-392, 1999.

[26] V. Rasche, D. Holz, and R. Proksa, "Multi-Gradient-Echo ( prMGE ) MRI," Magnetic resonance in medicine, vol. 42, pp. 324-334, 1999.

[27] L. I. Rudin, S. Osher, and E. Fatemi, "Nonlinear total variation based noise removal algorithms", vol. 60, pp. 259-268, 1992.

[28] S. J. Scrivani, D. a. Keith, and L. B. Kaban, "Temporomandibular disorders", The New England journal of medicine, vol. 359, no. 25, pp. 2693-705, Dec. 2008.

[29] K. P. Pruessmann, M. Weiger, M. B. Scheidegger, and P. Boesiger, "SENSE: sensitivity encoding for fast MRI." Magnetic resonance in medicine, vol. 42, no. 5, pp. 952-962, Nov. 1999.

[30] M. A. Griswold, P. M. Jakob, R. M. Heidemann, M. Nittka, V. Jellus, J. Wang, B. Kiefer, and A. Haase, "Generalized autocalibrating partially parallel acquisitions (GRAPPA)", Magnetic resonance in medicine, vol. 47, no. 6, pp. 1202-1210, Jun. 2002.

[31] S. Wundrak, J. Paul, J. Ulrici, E. Hell, and V. Rasche, "Sparse Dynamic MRI of the Temporomandibular Joint", Proc. Intl. Soc. Mag. Reson. Med., vol. 9, no. 1, 2014, p. 1267.

[32] S. Winkelmann, T. Schaeffter, H. Eggers, T. Nielsen, and O. Doessel, "Single Shot T1-Mapping, using a Radial Look-Locker Sequence and an optimal Profile Order determined by the Golden Cut", Proc. Intl. Soc. Mag. Reson. Med., 2005, p. 2196.

[33] Markl, M., & Leupold, J., "Eddy current compensation with N-average SSFP imaging ", US 7,372,266 B2, (2008).

[34] Donoho, D. L., Santos, J. M., & Pauly, J. M., "Compressed Sensing MRI", IEEE Signal Processing Magazine, 2008, (http://www.eecs.berkeley.edu/~mlustig/CS/CSMRI.pdf).

[35] Ehses, P., Seiberlich, N., Ma, D., Breuer, F. a, Jakob, P. M., Griswold, M. a, & Gulani, V., "IR TrueFISP with a golden-ratio-based radial readout: fast quantification of T1, T2, and proton density", Magnetic Resonance in Medicine, 69(1), 71-81, 2013.

[36] Fesssler, J. A., "Model-based image reconstruction for MRI", IEEE Signal Processing Magazine, 27(4), 81-89, 2010.

[37] Y.-C. Kim et al., "Pseudo golden-ratio spiral imaging with gradient acoustic noise cancellation: application to real-time MRI of fluent speech", Proc. Intl. Soc. Mag. Reson. Med. 20, 2012, S. 4209.

[38] H. Eggers et al., "Magnetic resonance device and method", WO 2008/132659 A2, 2008.

**Patentansprüche**

1. Verfahren zur Erstellung einer MRI-Aufnahme, bei dem eine radiale oder spiralförmige k-Raum-Trajektorie mit einem konstanten Winkelinkrement Psi benutzt wird, **dadurch gekennzeichnet, dass** das Winkelinkrement Psi in einem Winkelbereich von 5 bis 55 Grad liegt und berechnet wird nach der Formel

$$\psi_{N,M} = \frac{\pi}{N + \frac{1}{M+\tau-1}}$$

wobei N zwischen 3 und 35 liegt und
wobei M zwischen 1 und 5 liegt und
wobei tau gleich (1+sqrt(5))/2 ist.

2. Verfahren nach Anspruch 1, **dadurch gekennzeichnet, dass** M = 1 und N mindestens 3 ist, sodass sich für das Winkelinkrement Psi die folgende Formel ergibt:

$$\psi_N = \frac{\pi}{\tau + N - 1}$$

wobei N zwischen 3 und 35 liegt und
wobei tau = (1+sqrt(5))/2 ist.

3. Verfahren nach Anspruch 1, **dadurch gekennzeichnet, dass** M = 2 ist.

4. Verfahren nach Anspruch 2, **dadurch gekennzeichnet, dass** N mindestens 5, vorzugsweise mindestens 7 ist.

5. Verfahren nach einem der Ansprüche 1 bis 4, **dadurch gekennzeichnet, dass** für eine Weiterverarbeitung, insbesondere für eine Rekonstruktion eine Anzahl n von Profilen gewählt wird, wobei die Anzahl n Teil einer modifizierten Fibonacci-Folge $G^{N,M}$ ist mit

$$G^{N,M}_1 = 1+(M-1)N, \quad G^{N,M}_2 = N, \quad G^{N,M}_n = G^{N,M}_{n-1} + G^{N,M}_{n-2}.$$

6. Verfahren nach einem der Ansprüche 1 bis 5, **dadurch gekennzeichnet, dass** pro Winkelposition mindestens zwei Profile gemessen werden.

7. Verfahren nach einem der Ansprüche 1 bis 6, **dadurch gekennzeichnet, dass** verbleibende Wirbelstrom-Artefakte über ein "through-slice equilibration"-Verfahren reduziert werden.

**Claims**

1. A method for producing an MRI image, in which a radial or spiral k-space trajectory with a constant angular increment Psi is used,
**characterized in that** the angular increment Psi lies in an angular range of 5 to 55 degrees and is calculated according to the formula

$$\psi N, M = \frac{\pi}{N + \dfrac{1}{M + \tau - 1}}$$

wherein N lies between 3 and 35 and
wherein M lies between 1 and 5 and
wherein tau is equal to (1+sqrt(5)) / 2.

2. The method according to claim 1, **characterized in that** M = 1 and N is at least 3, so that the following formula results for the angular increment Psi:

$$\psi N = \frac{\pi}{\tau + N - 1}$$

wherein N lies between 3 and 35 and
wherein tau = (1+sqrt(5)) / 2.

3. The method according to claim 1, **characterized in that** M = 2.

4. The method according to claim 2, **characterized in that** N is at least 5, preferably at least 7.

5. The method according to one of claims 1 to 4, **characterized in that** a number n of profiles is selected for further processing, in particular for a reconstruction, wherein the number n is a part of a modified Fibonacci sequence $G^{N,M}$ with

$$G^{N,M}_1 = 1 + (M-1)N, \ G^{N,M}_2 = N, \ G^{N,M}_n = G^{N,M}_{n-1} + G^{N,M}_{n-2}.$$

6. The method according to one of claims 1 to 5, **characterized in that** at least two profiles are measured per angular position.

7. The method according to one of claims 1 to 6, **characterized in that** remaining eddy current artefacts are reduced by means of a "through-slice equilibration" method.

**Revendications**

1. Procédé pour la création d'une image par IRM, selon lequel on utilise une trajectoire de l'espace k radiale ou en spirale avec un incrément angulaire constant Psi,
**caractérisé en ce que** l'incrément angulaire Psi se situe dans une plage angulaire de 5 à 55 degrés et est calculé selon la formule

$$\psi N, M = \frac{\pi}{N + \dfrac{1}{M + \tau - 1}}$$

dans laquelle N est compris entre 3 et 35 et
dans laquelle M est compris entre 1 et 5 et
dans laquelle tau est égal à (1 + sqrt(5)) / 2.

2. Procédé selon la revendication 1, **caractérisé en ce que** M = 1 et N est au moins égal à 3, de sorte que l'incrément angulaire Psi se calcule selon la formule suivante :

$$\psi N = \frac{\pi}{\tau + N - 1}$$

dans laquelle N est compris entre 3 et 35 et
dans laquelle tau = (1 + sqrt(5)) / 2.

3. Procédé selon la revendication 1, **caractérisé en ce que** M = 2.

4. Procédé selon la revendication 2, **caractérisé en ce que** N est au moins égal à 5, de préférence au moins égal à 7.

5. Procédé selon l'une des revendications 1 à 4, **caractérisé en ce que** pour un traitement ultérieur, en particulier pour une reconstruction, un nombre n de profils est choisi, dans lequel le nombre n fait partie d'une suite de Fibonacci modifiée $G^{N,M}$ avec

$$G^{N,M}_1 = 1+(M-1)N, \quad G^{N,M}_2 = N, \quad G^{N,M}_n = G^{N,M}_{n-1} + G^{N,M}_{n-2}.$$

6. Procédé selon l'une des revendications 1 à 5, **caractérisé en ce qu'**au moins deux profils sont mesurés par position angulaire.

7. Procédé selon l'une des revendications 1 à 6, **caractérisé en ce que** les artefacts résiduels de courants de Foucault sont réduits par un procédé de « through-slice équilibration ».

| N | M | $Psi_{N,M}$ | $G_4^{N,M}$ | $G_5^{N,M}$ | $G_6^{N,M}$ | $G_7^{N,M}$ | $G_8^{N,M}$ | $G_9^{N,M}$ | Grenzen von $SE_{n>2N}^{Psi_{N,M}}$ |
|---|---|---|---|---|---|---|---|---|---|
| 1 | 1 | 111.2461...° | 3 | 5 | 8 | 13 | 21 | 34 | [ 0.973, 0.996 ] |
| 2 | 1 | 68.7538...° | 5 | 8 | 13 | 21 | 34 | 55 | [ 0.973, 0.996 ] |
| 3 | 1 | 49.7507...° | 7 | 11 | 18 | 29 | 47 | 76 | [ 0.972, 0.996 ] |
| 4 | 1 | 38.9776...° | 9 | 14 | 23 | 37 | 60 | 97 | [ 0.973, 0.997 ] |
| 5 | 1 | 32.0396...° | 11 | 17 | 28 | 45 | 73 | 118 | [ 0.973, 0.998 ] |
| 6 | 1 | 27.1984...° | 13 | 20 | 33 | 53 | 86 | 139 | [ 0.973, 0.998 ] |
| 7 | 1 | 23.6281...° | 15 | 23 | 38 | 61 | 99 | 160 | [ 0.973, 0.998 ] |
| 2 | 2 | 75.5678...° | 7 | 12 | 19 | 31 | 50 | 81 | [ 0.974, 0.996 ] |
| 2 | 3 | 79.0725...° | 9 | 16 | 25 | 41 | 66 | 107 | [ 0.974, 0.996 ] |
| 3 | 2 | 53.2235...° | 10 | 17 | 27 | 44 | 71 | 115 | [ 0.974, 0.996 ] |
| 3 | 3 | 54.9385...° | 13 | 23 | 36 | 59 | 95 | 154 | [ 0.974, 0.996 ] |
| 4 | 2 | 41.0775...° | 13 | 22 | 35 | 57 | 92 | 149 | [ 0.973, 0.996 ] |

## Fig. 1

Fig. 2

| | n = 3 | n = 5 | n = 11 | n = 15 | n = 28 | n = 61 |
|---|---|---|---|---|---|---|
| $\Psi_1 = 111.2461179...°$ | | | | | | |
| | 0.995 | 0.996 | 0.974 | 0.980 | 0.974 | 0.982 |
| $\Psi_3 = 49.7507764...°$ | | | | | | |
| | 0.993 | 0.965 | 0.995 | 0.974 | 0.988 | 0.975 |
| $\Psi_5 = 32.0396780...°$ | | | | | | |
| | 0.950 | 0.991 | 0.998 | 0.978 | 0.996 | 0.974 |
| $\Psi_7 = 23.6281434...°$ | | | | | | |
| | 0.919 | 0.922 | 0.953 | 0.998 | 0.974 | 0.995 |

## Fig. 3

## Fig. 4

Fig. 5

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2013159044 A1
- WO 2008132659 A2

- US 7372266 B2, Markl, M., & Leupold, J.

**In der Beschreibung aufgeführte Nicht-Patentliteratur**

- **P. C. LAUTERBUR.** Image Formation by Induced Local Interactions. *Nature,* 1973, vol. 242 (190
- **V. RASCHE ; R. DE BOER ; D. HOLZ ; R. PROKSA.** Continuous radial data acquisition for dynamic MRI. *Magn Reson Med,* 1995, vol. 34 (5), 754-61
- **S. WINKELMANN ; T. SCHAEFFTER ; T. KOEHLER ; H. EGGERS ; O. DOESSEL.** An optimal radial profile order based on the Golden Ratio for time-resolved MRI. *IEEE transactions on medical imaging,* Januar 2007, vol. 26 (1), 68-76
- **L. FENG ; R. GRIMM ; K. TOBIAS BLOCK ; H. CHANDARANA ; S. KIM ; J. XU ; L. AXEL ; D. K. SODICKSON ; R. OTAZO.** Golden-angle radial sparse parallel MRI: Combination of compressed sensing, parallel imaging, and golden-angle radial sampling for fast and flexible dynamic volumetric MRI. *Magnetic resonance in medicine,* 2014, vol. 72, 707-717
- **A. J. HOPFGARTNER ; O. TYMOFIYEVA ; P. EHSES ; K. ROTTNER ; J. BOLDT ; E.-J. RICHTER ; P. M. JAKOB.** Dynamic MRI of the TMJ under physical load. *Dento maxillo facial radiology,* 09. Januar 2013, vol. 42
- **J. LIU ; P. SPINCEMAILLE ; N. C. F. CODELLA ; T. D. NGUYEN ; M. R. PRINCE ; Y. WANG.** Respiratory and cardiac self-gated free-breathing cardiac CINE imaging with multiecho 3D hybrid radial SSFP acquisition. *Magnetic resonance in medicine,* Mai 2010, vol. 63, 1230-7
- **J. PAUL ; E. DIVKOVIC ; S. WUNDRAK ; P. BERNHARDT ; W. ROTTBAUER ; H. NEUMANN ; V. RASCHE.** High-resolution respiratory self-gated golden angle cardiac MRI: Comparison of self-gating methods in combination with k-t SPARSE SENSE. *Magnetic Resonance in Medicine,* Januar 2014
- **A. D. SCOTT ; R. BOUBERTAKH ; M. J. BIRCH ; M. E. MIQUEL.** Adaptive Averaging Applied to Dynamic Imaging of the Soft Palate. *Magnetic resonance in medicine,* 2013, vol. 70, 865-874

- **H. K. SONG ; L. DOUGHERTY.** k-space weighted image contrast (KWIC) for contrast manipulation in projection reconstruction MRI. *Magnetic resonance in medicine,* Dezember 2000, vol. 44 (6), 825-32
- **M. DONEVA.** Advances in Compressed Sensing for Magnetic Resonance Imaging. *Dissertation,* 2011
- **M. USMAN ; D. ATKINSON ; F. ODILLE ; C. KOLBITSCH ; G. VAILLANT ; T. SCHAEFFTER ; P. G. BATCHELOR ; C. PRIETO.** Motion Corrected Compressed Sensing for Free-Breathing Dynamic Cardiac MRI. *Magnetic resonance in medicine,* 2013, vol. 70, 504-516
- **M. DONEVA ; H. EGGERS ; J. RAHMER ; P. B"ORNERT ; A. MERTINS.** Highly Undersampled 3D Golden Ratio Radial Imaging with Iterative Reconstruction. *Proc. Intl. Soc. Mag. Reson. Med.,* 2008, vol. 16, 336
- Compressed Sensing MRI. **M. LUSTIG ; D. L. DONOHO ; J. M. SANTOS ; J. M. PAULY.** Signal Processing Magazine. IEEE, 2008, vol. 25, 72-82
- **R. W. CHAN ; E. A. RAMSAY ; E. Y. CHEUNG ; D. B. PLEWES.** *Magnetic resonance in medicine,* 2012, vol. 67, 363-377
- **A. OPPELT ; R. GRAUMANN ; H. BARFUSS ; H. FISCHER ; W. HARTL ; W. SCHAJOR.** FISP - a new fast MRI sequence. *Electromedia,* 1986, vol. 54, 15-18
- **O. BIERI ; M. MARKL ; K. SCHEFFLER.** Analysis and Compensation of Eddy Currents in Balanced SSFP. *Magnetic resonance in medicine,* 2005, vol. 54, 129-137
- **C. M. TSAI ; D. G. NISHIMURA.** Reduced aliasing artifacts using variable-density k-space sampling trajectories. *Magnetic resonance in medicine,* Marz 2000, vol. 43, 452-458
- **C. MARZEC ; J. KAPPRAFF.** Properties of Maximal Spacing on a Circle Related to Phyllotaxis and to the Golden Mean. *Journal of Theoretical Biology,* 1983, vol. 103, 201-226

- **A. F. HORADAM.** A Generalized Fibonacci Sequence. *Amer. Math. Monthly,* 1961, vol. 69 (8), 455-459
- **D. E. KNUTH.** The Art of Computer Programming. Addison-Wesley, 1973, vol. 3, 543
- History of the Theory of Numbers. **L. E. DICKSON.** Divisibility and Primality. Dover, 2005, vol. 1
- **S. VAJDA, FIBONACCI ; LUCAS NUMBERS.** *Golden Section - Theory and Applications,* 1989
- **S. ZHANG ; N. GERSDORFF ; J. FRAHM.** Real-Time Magnetic Resonance Imaging of Temporomandibular Joint Dynamics. *The Open Medical Imaging Journal,* 2011, vol. 5, 1-7
- **A. HAASE ; D. MATTHAEI ; W. H''ANICKE ; K.-D. MERBOLDT.** FLASH imaging. Rapid NMR imaging using low flipangle pulses. *Journal of Magnetic Resonance,* 1986, vol. 67, 258-266
- **V. RASCHE ; R. PROSKA ; R. SINKUS ; P. BÖRNERT ; H. EGGERS.** Resampling of Data Between Arbitrary Grids Using Convolution Interpolation. *IEEE transactions on medical imaging,* 1999, vol. 18 (5), 385-392
- **V. RASCHE ; D. HOLZ ; R. PROKSA.** Multi-Gradient-Echo ( prMGE ) MRI. *Magnetic resonance in medicine,* 1999, vol. 42, 324-334
- **L. I. RUDIN ; S. OSHER ; E. FATEMI.** *Nonlinear total variation based noise removal algorithms,* 1992, vol. 60, 259-268
- **S. J. SCRIVANI ; D. A. KEITH ; L. B. KABAN.** Temporomandibular disorders. *The New England journal of medicine,* Dezember 2008, vol. 359 (25), 2693-705
- **K. P. PRUESSMANN ; M. WEIGER ; M. B. SCHEIDEGGER ; P. BOESIGER.** SENSE: sensitivity encoding for fast MRI. *Magnetic resonance in medicine,* November 1999, vol. 42 (5), 952-962
- **M. A. GRISWOLD ; P. M. JAKOB ; R. M. HEIDEMANN ; M. NITTKA ; V. JELLUS ; J. WANG ; B. KIEFER ; A. HAASE.** Generalized autocalibrating partially parallel acquisitions (GRAPPA). *Magnetic resonance in medicine,* Juni 2002, vol. 47 (6), 1202-1210
- **S. WUNDRAK ; J. PAUL ; J. ULRICI ; E. HELL ; V. RASCHE.** Sparse Dynamic MRI of the Temporomandibular Joint. *Proc. Intl. Soc. Mag. Reson. Med.,* 2014, vol. 9 (1), 1267
- **S. WINKELMANN ; T. SCHAEFFTER ; H. EGGERS ; T. NIELSEN ; O. DOESSEL.** Single Shot T1-Mapping, using a Radial Look-Locker Sequence and an optimal Profile Order determined by the Golden Cut. *Proc. Intl. Soc. Mag. Reson. Med.,* 2005, 2196
- **DONOHO, D. L. ; SANTOS, J. M. ; PAULY, J. M.** Compressed Sensing MRI. *IEEE Signal Processing Magazine,* 2008, http://www.eecs.berkeley.edu/~mlustig/CS/CSMRI.pdf
- **EHSES, P. ; SEIBERLICH, N. ; MA, D. ; BREUER, F. A ; JAKOB, P. M. ; GRISWOLD, M. A ; GULANI, V.** IR TrueFISP with a golden-ratio-based radial readout: fast quantification of T1, T2, and proton density. *Magnetic Resonance in Medicine,* 2013, vol. 69 (1), 71-81
- **FESSSLER, J. A.** Model-based image reconstruction for MRI. *IEEE Signal Processing Magazine,* 2010, vol. 27 (4), 81-89
- **Y.-C. KIM et al.** Pseudo golden-ratio spiral imaging with gradient acoustic noise cancellation: application to real-time MRI of fluent speech. *Proc. Intl. Soc. Mag. Reson. Med.,* 2012, vol. 20, 4209